# EUROPEAN PATENT SPECIFICATION

(11) **EP 1 478 030 B1**
(45) Date of publication and mention of the grant of the patent: **13.11.2013**
(21) Application number: 03734617.8
(22) Date of filing: 27.01.2003
(51) Int. Cl.: H01L 31/076, H01L 31/0236

(54) **TANDEM THIN-FILM PHOTOELECTRIC TRANSDUCER AND ITS MANUFACTURING METHOD**
FOTOELEKTRISCHER TANDEM-DÜNNFILMWANDLER UND VERFAHREN ZU SEINER HERSTELLUNG
TRANSDUCTEUR PHOTOELECTRIQUE A FILM MINCE EN TANDEM ET SON PROCEDE DE FABRICATION

(30) Priority: 28.01.2002 JP 2002019225; 20.03.2002 JP 2002079823; 27.12.2002 JP 2002380062
(43) Date of publication of application: 17.11.2004
(73) Proprietor: Kaneka Corporation, Osaka (JP)
(72) Inventor: FUKUDA, Susumu, Otsu-shi, Shiga 520-0026 (JP); TAWADA, Yuko, Settsu-shi, Osaka 566-0073 (JP); KOI, Youhei, Otsu-shi, Shiga 520-0103 (JP); YAMAMOTO, Kenji, Kobe-shi, Hyogo 651-2277 (JP)
(74) Representative: Vossius & Partner
(86) International application number: PCT/JP2003/000753
(87) International publication number: WO 2003/065462

(56) References cited:
- EP-A1- 1 100 130
- JP-A- 3 125 481
- JP-A- 7 066 435
- JP-A- 7 066 435
- JP-A- 11 284 213
- JP-A- 60 111 478
- JP-A- 60 111 478
- JP-A- 2002 222 969
- US-A1- 2002 134 425
- FISCHER D ET AL: "The micromorph solar cell: extending a-Si:H technology towards thin film crystalline silicon" 19960513; 19960513 - 19960517, 13 May 1996 (1996-05-13), pages 1053-1056, XP010208332

## Description

### Technical Field

The present invention relates to improvement in photoelectric conversion efficiency of a thin film photoelectric converter, and more particularly to improvement in conversion efficiency of a tandem thin film photoelectric converter including a plurality of stacked photoelectric conversion units. In the present specification, terms "crystalline" and "microcrystalline" are used also for a state partially including amorphous regions, as generally used in the field of the art.

### Background Art

In order to reduce costs of photoelectric converters and at the same time to improve conversion efficiencies thereof, thin film photoelectric converters which are also preferable in view of saving natural resources have attracted attention in recent years and have been developed with intensive effort. Thin film photoelectric converters are expected to be employed in various applications such as solar batteries, optical sensors, displays and the like. An amorphous silicon photoelectric converter, as one example of thin film photoelectric converters, can be formed on a glass or stainless steel substrate of a large area at a relatively low temperature and thus is expected to enable cost reduction.

In general, a thin film photoelectric converter includes a first electrode, one or more semiconductor thin film photoelectric conversion units and a second electrode stacked in sequence on an insulative surface of a substrate. Further, one thin film photoelectric conversion unit includes an i-type layer sandwiched between a p-type layer and an n-type layer.

A major portion of thickness of the thin film photoelectric conversion unit is occupied by the i-type layer of substantially intrinsic semiconductor and then photoelectric conversion occurs mainly in the i-type layer. Accordingly, it is preferable that the i-type layer as a photoelectric conversion layer has a greater thickness for a purpose of light absorption, though increase of the thickness increases costs and time for deposition of the i-type layer.

On the other hand, the p-type and n-type conductive layers serve to produce a diffusion potential within the photoelectric conversion unit, and magnitude of the diffusion potential affects the value of open-circuit voltage (Voc) which is one of important properties of the thin film photoelectric converter. However, these conductive layers are inactive layers which do not contribute to photoelectric conversion. That is, light absorbed by impurities doped in the conductive layers does not contribute to power generation and becomes loss. Consequently, it is preferable to minimize the thickness of the p-type and n-type conductive layers as far as they provide a sufficient diffusion potential.

In general, the light absorption coefficient of semiconductor used in photoelectric conversion layer decreases as the wavelength of light increases. Consequently, when photoelectric conversion material is provided as a thin film, sufficient light absorption may not be achieved in a longer wavelength range where the light absorption coefficient is small and the amount of photoelectric conversion is limited by the thickness of the photoelectric conversion layer. Accordingly, schemes have been developed to provide a light scattering structure for preventing light incident on the photoelectric converter from escaping to the outside, thereby extending the effective light path within the photoelectric conversion layer to cause sufficient light absorption and produce large photocurrent. For example, in the case that light comes in through a transparent substrate, a textured transparent conductive film having an uneven surface geometry is used as a light incident side electrode (see. Japanese Patent Laying-Open No. 58-57756, for example).

Another known method of improving the conversion efficiency of the thin film photoelectric converter involves stacking two or more photoelectric conversion units in tandem. In this method, a front unit including a photoelectric conversion layer having a wider energy band gap is disposed closer to the light incident side of the photoelectric converter, and behind it a rear unit including a photoelectric conversion layer (of a Si-Ge alloy, for example) having a narrower band gap is disposed, thereby enabling photoelectric conversion over a wide wavelength range of incident light to improve the conversion efficiency of the entire device. A tandem thin film photoelectric converter including an amorphous photoelectric conversion unit and a crystalline photoelectric conversion unit is called a hybrid thin film photoelectric converter.

For example, in a hybrid thin film photoelectric converter having an amorphous silicon photoelectric conversion unit including an amorphous silicon photoelectric conversion layer of a wider band gap and a crystalline silicon photoelectric conversion unit including a crystalline silicon photoelectric conversion layer of a narrower band gap, the wavelength of light which can be converted to electricity by amorphous silicon is no longer than approximately 800 nm, but light of longer wavelength up to approximately 1100 nm can be converted to electricity by crystalline silicon, whereby enabling more effective photoelectric conversion of incident light over a wider wavelength range.

In the tandem photoelectric converter, a plurality of photoelectric conversion units are connected in series so that the short-circuited current density (Jsc) in the photoelectric converter is limited by the minimum of the values of currents generated in the photoelectric conversion units. Consequently, the current values of the plurality of photoelectric conversion units are preferably large and equivalent to each other, thereby enabling improvement in conversion efficiency of the entire photoelectric converter.

Incidentally, a conductive intermediate layer having a refractive index different from that of the photoelectric conversion material may be inserted between the stacked photoelectric conversion units. Such an intermediate layer is partially light-transmissible and partially light-reflective in the photoelectric converter. In this case, light reaching the intermediate layer is partially reflected so that the photoelectric conversion unit between the intermediate layer and the light incident side can absorb an increased amount of light, thereby increasing the amount of current generated therein. This is equivalent to an increase in effective thickness of the photoelectric conversion unit located between the intermediate layer and the light incident side.

For example, in the case that the intermediate layer is inserted in a hybrid photoelectric converter which includes an amorphous silicon photoelectric conversion unit and a crystalline silicon photoelectric conversion unit stacked in this order from the light incident side, current generated in the amorphous silicon photoelectric conversion unit can be increased without increasing thickness of that unit. Alternatively, in that case, thickness of the amorphous silicon layer can be reduced to maintain the same current value as in the case of not including the intermediate layer, and thus it becomes possible to minimize optical deterioration (Staebler-Wronski effect) in properties of the amorphous silicon photoelectric conversion unit. That is , the optical deterioration becomes more significant as the thickness of the amorphous silicon layer is increased.

Such an intermediate layer is usually formed by a method such as sputtering, vapor deposition, electron beam (EB) evaporation or the like. However, vapor deposition and EB evaporation are not so suitable for forming a film of a large area and they make it difficult to form an intermediate layer having uniform thickness and quality over a photoelectric conversion unit of a large area. Although it is relatively easy to form a film of a large area by sputtering, a high voltage typically at several hundreds volts to several kilo volts needs to be applied to emit atoms and/or radicals from a target surface and enable them to reach an underlayer surface. As such, large kinetic energy of atoms and radicals reaching the underlayer surface is liable to damage the underlayer during formation of the intermediate layer, and thus it cannot be guaranteed that the intermediate layer improves the properties of the photoelectric converter.

In Japanese Patent Laying-Open No. 7-66435 for example, there is disclosed a tandem photoelectric converter including a plurality of light scattering layers, each of which has an uneven surface geometry. Japanese Patent Laying-Open No. 7-66435 proposes a tandem photoelectric converter in which a product nxd of a refractive index n and a height difference d of surface unevenness of a light scattering layer disposed in the rear is set to be larger than that of another light scattering layer close to the light incident side of the converter to increase the degree of scattering of incident light, thereby enabling more efficient use of incident light without causing problems such as open-circuit voltage reduction and inner short-circuiting. This is intended to address the problem of the inner short-circuiting which is liable to occur if a front photoelectric conversion unit having a thickness less than 200 nm is formed on an electrode layer close to the light incident side (which also serves as a light scattering layer) having large height difference in its surface unevenness. For a specific example, the height difference d of surface unevenness of the electrode layer close to the light incident side is set to be 50 nm, the overlying amorphous silicon photoelectric conversion unit is made to a thickness of approximately 100 nm, and a zinc oxide layer with a thickness in a range of 100 nm to 2000 nm is formed as the overlying light scattering layer by MOCVD, whereby improving conversion efficiency.

In the hybrid thin film photoelectric converter, the short-circuited current density is typically limited by the amount of absorbed light in the amorphous silicon photoelectric conversion unit. Thus, to achieve high photoelectric conversion efficiency, it is desirable that the thickness of the amorphous silicon photoelectric conversion unit is made more than 230 nm, even when the height difference d (as in Japanese Patent Laying-Open No. 7-66435) of surface unevenness of the electrode close to the light incident side is set to be at least 80 nm.

In the case of inserting the intermediate layer, the intermediate layer reflects part of the incident light, reducing the amount of transmitted light reaching the photoelectric conversion unit behind the intermediate layer, i.e., the unit for absorbing longer-wavelength light for conversion to electricity. In the case of the hybrid thin film photoelectric converter, the crystalline silicon photoelectric conversion unit has a smaller absorption coefficient in a longer wavelength range and thus needs to have a greater thickness and, if the amount of transmitted light is decreased, needs to have a still larger thickness. However, an excessively large thickness of the photoelectric conversion layer is not preferable, because it increases influence of film quality of the layer on the conversion efficiency to a non-negligible level. Also, the photoelectric conversion layer with an excessively large thickness is not preferable, since it requires a longer time for deposition and reduces productivity of the photoelectric converter.

A further problem is that the underlying photoelectric conversion unit may be damaged during formation of the intermediate layer and then the interface joining this unit and the intermediate layer may be degraded, causing reduction in fill factor (F.F.) of the entire photoelectric converter.

A tandem photoelectric converter including an intermediate layer is also known from Fircher et al., the "micromorph" solar cell: extending a-Si:H technology towards thin film crystalline silicon, 25th PVSC, May 13-17, 1996.

### Disclosure of the Invention

In view of the above-described circumstances of the prior art, a main object of the present invention is to further improve the conversion efficiency (Eff.) of the tandem thin film photoelectric converter.

This object is solved by a method according to claim 1.

By providing the uneven surface geometry having the specified average peak-to-peak pitch on the intermediate layer having the specified thickness, it becomes possible to dramatically improve the light trapping effect of the photoelectric conversion units on both sides of the intermediate layer to achieve high photoelectric conversion efficiency. Specifically, light entering the photoelectric converter is partially reflected by the intermediate layer to the front unit to increase output current of the front unit, while in the rear unit area, light having passed through the intermediate layer is then scattered by the uneven surface geometry of the intermediate layer to be trapped between the back electrode and the intermediate layer.

In addition to the fine surface unevenness of the intermediate layer, an uneven geometry is also provided on the surface of the transparent electrode to further improve the light trapping effect. That is, it is possible to advantageously improve the light trapping effect by the uneven surface of the transparent electrode itself, and then the light trapping effect of the intermediate layer can also be improved by superposing on the first uneven surface geometry inherent in the intermediate layer a second uneven surface geometry caused by the uneven surface geometry of the transparent electrode.

The plurality of photoelectric conversion units includes one or more amorphous photoelectric conversion units and one or more crystalline photoelectric conversion units. Further, the intermediate layer includes as its main component a transparent conductive oxide containing zinc oxide, tin oxide or indium-tin oxide. Further, the transparent electrode includes an uneven surface geometry having an average peak-to-peak pitch of 200-900 nm.

In the method of manufacturing the tandem thin film photoelectric converter according to the present invention, the intermediate layer is formed by chemical vapor deposition. Further, it is preferable to form the intermediate layer on an amorphous photoelectric conversion unit and then form thereupon a crystalline photoelectric conversion unit. During chemical vapor deposition of the intermediate layer, it is preferable that all source materials are introduced in their vapor phases into a deposition chamber from the outside. Further, it is preferable to form the intermediate layer directly after the amorphous photoelectric conversion unit has been formed, without the upper surface of that unit being exposed to the ambient air.

### Brief Description of the Drawings

Fig. 1 is a schematic cross sectional view of an exemplary tandem thin film photoelectric converter of the present invention.
Fig. 2 is an atomic force microscopy (AFM) image showing an exemplary uneven surface geometry of intermediate layer 3 in the present invention.
Fig. 3 is a graph showing the height difference by AFM measurement of an exemplary uneven surface geometry of intermediate layer 3 in the present invention.
Fig. 4 is a graph showing the height difference of an exemplary uneven surface geometry of a zinc oxide film formed on a glass plate under the same conditions as in the MOCVD method in Example 1.
Fig. 5 is an AFM image showing an exemplary uneven surface geometry of a zinc oxide film formed on a glass plate under the same conditions as in the sputtering method in Example 2.
Fig. 6 is a graph showing the height difference by AFM measurement of an exemplary uneven surface geometry of a zinc oxide film formed on a glass plate under the same conditions as in the sputtering method in Example 2.

### Best Modes for Carrying Out the Invention

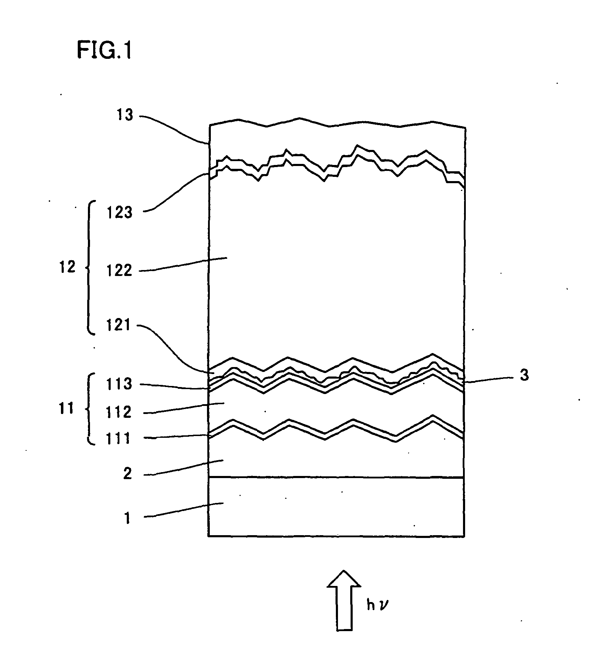

In Fig. 1, a tandem thin film photoelectric converter according to an embodiment of the present invention is shown in a schematic cross section. The photoelectric converter includes, on a transparent substrate 1, a transparent electrode 2, a first photoelectric conversion unit 11, an intermediate layer 3, a second photoelectric conversion unit 12, and a back electrode 13 stacked in sequence. First photoelectric conversion unit 11 includes a first conductivity type layer 111, a photoelectric conversion layer 112 of substantially intrinsic semiconductor and a second conductivity type layer 113 stacked in sequence. Similarly, second photoelectric conversion unit 12 includes a first conductivity type layer 121, a photoelectric conversion layer 122 of substantially intrinsic semiconductor, and a second conductivity type layer 123 stacked in sequence.

Transparent insulative substrate 1 used in the photoelectric converter of Fig. 1 can be a glass plate, a film or the like, and is preferably as transparent as possible to transmit more sunlight for absorption in the photoelectric conversion layers. For a similar purpose, a non-reflective coating may be provided to reduce light reflection loss at the lower surface of the substrate through which sunlight (hv) comes in, thereby improving efficiency of the photoelectric converter.

Transparent electrode 2 is made of transparent conductive oxide (TCO). Materials forming the transparent electrode TCO may include tin oxide, indium-tin oxide (ITO), zinc oxide or the like, where tin oxide is particularly preferable. The upper surface of transparent electrode 2 has a surface unevenness with an average peak-to-peak pitch in a range of 200-900 nm, and thus it is preferable to form transparent electrode 2 by a TCO having an average grain size in the range of 200-900 nm.

The surface unevenness of transparent electrode 2 as described above not only promotes light scattering but also is transferred onto the surface of intermediate layer 3 through first photoelectric conversion unit 11. On a surface unevenness which is inherently generated by intermediate layer 3 itself, a second surface unevenness caused by the surface unevenness of transparent electrode 2 is superposed and then produce a more complicated total surface unevenness of intermediate layer 3, so that light scattering due to intermediate layer 3 can further be improved. In consideration of the degree of light scattering in transparent electrode 2 and the transfer of the surface unevenness of electrode 2 to intermediate layer 3, it is preferable that transparent electrode 2 has a grain size in the above-mentioned range of 200-900 nm.

Thermal CVD (chemical vapor deposition) can preferably be utilized for a method of forming transparent electrode 2. Since transparent electrode 2 is located on the light incident side of the photoelectric converter, it is preferably as transparent as possible, similarly to substrate 1. For example, the total transmissivity of substrate 1 and transparent electrode 2 is preferably 80% or more with respect to light in a wavelength range of 500-1100 nm.

Although the device of Fig. 1 includes two photoelectric conversion units, it goes without saying that three or more units may be stacked. When three or more photoelectric conversion units are stacked, the intermediate layer may be inserted at each of interfaces between the photoelectric conversion units, or may be inserted at any selected interface.

The first conductivity type layer in the photoelectric conversion unit may be a p-type or n-type layer with the second conductivity type layer being an n-type or p-type layer, respectively. However, since a p-type layer is usually disposed closer to a light incident side in a photoelectric converter, first conductivity type layers 111 and 121 are usually p-type layers and second conductivity type layers 113 and 123 are usually n-type layers in such a device as shown in Fig. 1.

Since photoelectric conversion layers 112 and 122 of substantially intrinsic semiconductor serve to absorb light and to convert it into electricity, it is preferable that they have different band gaps, i.e., light absorption wavelength ranges different from each other and then they together have their total absorption range in the main wavelength range of sunlight (400-1200 nm). For example, it is preferable to select a combination of an amorphous silicon photoelectric conversion layer and an amorphous silicon-germanium photoelectric conversion layer; a combination of an amorphous silicon photoelectric conversion layer and a crystalline silicon photoelectric conversion layer; and the like.

In the device of Fig. 1, when an amorphous silicon-based thin film photoelectric conversion unit is formed as first photoelectric conversion unit 11, it is preferable to sequentially deposit semiconductor layers 111, 112 and 113 of p-i-n-types, respectively, by plasma CVD. In this case, for example, a p-type microcrystalline silicon-based layer 111 doped with 0.01 at.% or more of boron as impurity element for determining the conductivity type is first deposited, followed by an i-type amorphous silicon layer 112 as a photoelectric conversion layer and then an n-type microcrystalline silicon-based layer 113 doped with 0.01 at.% or more of phosphorus as impurity element for determining the conductivity type. Each of the conductive (p- or n-type) microcrystalline silicon-based layer preferably has a thickness in a range of 3 nm to 100 nm and more preferably in a range of 5 nm to 50 nm.

The p-i-n-type layers are not limited to this example and an amorphous silicon-based film, for example, may be used for the p-type layer. Further, the p-type layer may be made of an alloy material such as amorphous or microcrystalline silicon-carbide or silicon-germanium. That is, not only silicon but also semiconductor material such as amorphous or crystalline silicon-carbide or silicon-germanium containing 50% or more of silicon is also included in "silicon-based" material.

Intermediate layer 3 as one of the most important features of the present invention is intended to reflect part of light having reached it to front photoelectric conversion unit 11 and to transmit the rest of the light to rear unit 12, and accordingly it is preferably formed of a transparent thin film with a refractive index different from that of the photoelectric conversion material. Intermediate layer 3 must also pass electric current between the photoelectric conversion units and therefore is required to be conductive. When the photoelectric conversion layers are made of silicon-based materials usually having refractive indexes of approximately 3 to 3.5, it is preferable that intermediate layer 3 has a refractive index of about 1.4 to 2.7. More specifically, intermediate layer 3 is a transparent conductive thin film containing at least one of zinc oxide, tin oxide or ITO as its main material.

It is preferable to form intermediate layer 3 on photoelectric conversion unit 11 sequentially after formation of the unit without exposing the unit to the ambient air. Here, "without exposing to the ambient air" means maintaining an environment for preventing contamination or oxidation of the upper surface of unit 11 that is going to underlie intermediate layer 3, and it can be achieved by one of various usable methods.

Although no particular limitation is intended as to the method of forming intermediate layer 3 on photoelectric conversion unit 11, a preferable method can form intermediate layer 3 at a lower temperature with little damage to underlying photoelectric conversion unit 11. The intermediate layer is thus formed by chemical vapor deposition. For example, intermediate layer 3 can preferably be formed at a temperature of 200°C or less utilizing metal organic chemical vapor deposition (MOCVD).

Particularly, MOCVD or LPCVD (low pressure CVD) is most preferable because it causes less damage to the underlying layer. In either of these methods, intermediate layer 3 is formed by vapor phase reaction. "Vapor phase reaction" used herein means that all materials used for forming intermediate layer 3 are supplied in vapor phase into a deposition chamber, whereby causing a chemical reaction and depositing intermediate layer 3 on the underlying layer. Accordingly, the materials may be those that are in gaseous state at the normal temperature and pressure, or those that are solid or liquid at the normal temperature and pressure and can be vaporized by heating before being supplied into the deposition chamber.

In the case that intermediate layer 3 is a zinc oxide film, diethyl zinc and water may be used as source materials in MOCVD. It should be noted that, for example, dimethyl zinc may be used instead of diethyl zinc, and oxide or ozone may be used instead of water. Further, to improve conductivity of the zinc oxide film, it is effective to supply diborane gas at the same time. Instead of using diborane gas, the conductivity of the zinc oxide film may be improved by using boron trifluoride, boron trichloride or boron tribromide, or by vaporizing and supplying trimethyl boron which is liquid at room temperature.

Intermediate layer 3 has an average thickness in a range of 20 - 60 nm. The upper surface of intermediate layer 3 has a first uneven surface geometry of a prescribed average peak-to-peak pitch. Specifically, the average pitch is in a range of 10 - 50 nm and more preferable 20 - 40 nm. Here, it should be noted that the first uneven surface geometry means an uneven geometry that will be produced on the upper surface of intermediate layer 3 even if it is deposited on a flat underlying layer.

Intermediate layer 3 with an insufficient thickness cannot serve as a partially light reflecting layer, while that with an excess thickness transmits so less light that it becomes difficult to generate electric power in the rear photoelectric conversion unit. Further, too large a height difference of the first uneven surface geometry is not preferable either, because it causes electrical short circuits and/or mechanical defects in overlying thin conductive layer 121 within photoelectric conversion unit 12. MOCVD may preferably be used as a method that can appropriately form the first surface unevenness of intermediate layer 3. Incidentally, the thickness and the uneven surface geometry of intermediate layer 3 can be measured by cross-sectional transmission electron microscopy (cross sectional TEM) or atomic force microscopy (AFM).

When second photoelectric conversion unit 12 on intermediate layer 3 is a crystalline silicon-based photoelectric conversion unit, for example, it is also preferable to form p-i-n-type layers in sequence at a substrate temperature of 400°C or less by plasma CVD. A crystalline silicon-based photoelectric conversion layer as photoelectric conversion layer 122 is grown preferably at a low temperature so as to contain many hydrogen atoms which can terminate and deactivate dangling bonds existing along grain boundaries and within grains. Specifically, photoelectric conversion layer 122 preferably has a hydrogen content in a range of 1 - 30 at.%. Also, this layer 122 is preferably formed of substantially intrinsic semiconductor with a density of 1 × 10¹⁸ cm⁻³ or less of impurity atoms for determining the conductivity type.

Further, it is preferable that many grains contained in i-type crystalline silicon layer 122 grow to extend as columns in the layer thickness direction and have a preferential crystallographic plane of (110) parallel to the layer surface, because crystalline silicon thin film 122 with such a crystallographic plane causes a surface texture structure including fine unevenness on the upper surface of crystalline photoelectric conversion unit 12 deposited on transparent electrode 2 even if the upper surface of electrode 2 is substantially flat. In the case that the upper surface of transparent electrode 2 has a surface texture structure including unevenness, therefore, crystalline photoelectric conversion unit 12 tends to have its upper surface including a texture structure with an average peak-to-peak pitch smaller than that of the upper surface of transparent electrode 2, thereby providing a back structure which is suitable for scattering and reflecting light in a wide wavelength range and causes a significant light trapping effect.

I-type crystalline silicon layer 122 preferably has a thickness in a range of 0.1 µm to 10 µm. However, since it is preferable that a thin film photoelectric conversion unit causes absorption in the main wavelength range of sunlight (400 - 1200 nm), the i-type crystalline silicon layer may be substituted with an alloy material layer such as an amorphous silicon-carbide layer containing 10 at.% or less of carbon for example, or an amorphous silicon-germanium layer containing 30 at.% or less of germanium for example.

P-type crystalline silicon layer 121 in crystalline silicon-based photoelectric conversion unit 12 preferably has a thickness in a range of 3 nm to 25 nm. When p-type crystalline silicon layer 121 has a thickness smaller than 3 nm, it cannot sufficiently function as a p-type layer for producing an internal electric field that leads carriers generated within photoelectric conversion layer 122 toward the outside. When it has a thickness more than 25 nm, on the other hand, light absorption loss in p-type layer 121 itself is increased. Similarly to p-type layer 121, n-type crystalline silicon layer 123 preferably has a thickness in a range of 3 nm to 20 nm.

Back electrode 13 is preferably formed with one or more metal layers containing one or more metals selected from Al, Ag, Au, Cu, Pt and Cr, which are deposited by sputtering or vapor deposition. Furthermore, a TCO layer containing ITO, tin oxide or zinc oxide may be formed between photoelectric conversion unit 12 and the metallic electrode layer.

For example, it is preferable to form back electrode 13 with a double-layer film in which a zinc oxide film having a thickness of 10 nm to 150 nm and a silver film having a thickness of 30 nm to 500 nm are staked in this order. When the zinc oxide film has a thickness less than 10 nm, it cannot improve adhesiveness between crystalline silicon photoelectric conversion unit 12 and the silver film. When the zinc oxide film has a thickness more than 150 nm, on the other hand, light absorption due to the zinc oxide film itself is increased, leading to deterioration in the photoelectric conversion properties. The silver film serves to reflect longer-wavelength light which cannot easily be absorbed by crystalline silicon photoelectric conversion unit 12, and to enable it to enter unit 12 again. When the silver film has a thickness of 30 nm or less, its effect as a reflecting layer is drastically decreased. When the silver film has a thickness of 500 nm or more, on the other hand, it causes unnecessary increase of manufacturing costs.

In the following, examples of thin film photoelectric converters according to the present invention are described together with comparative examples, and Table 1 summarizes methods of fabricating the thin film photoelectric converters according to the examples and the comparative examples, while Table 2 summarizes measurement results of output characteristics of the resultant converters.

### (Example 1)

A hybrid thin film photoelectric converter as shown in Fig. 1 was fabricated as Example 1. On a square glass substrate 1 having a thickness of 1.1 mm and a side length of 127 mm, a tin oxide film having an average thickness of 800 nm and having a pyramidal surface unevenness was deposited by thermal CVD to form a transparent electrode 2. Obtained transparent electrode 2 had a sheet resistance of about 9 Ω/□. When glass substrate 1 with transparent electrode 2 formed thereon was illuminated by a standard light C having a specified wavelength distribution, its measured haze factor was 12%. Then, the average height difference d of unevenness on the upper surface of transparent electrode 2 was about 100 nm. An amorphous silicon photoelectric conversion unit 11 was formed on transparent electrode 2 by plasma CVD. Unit 11 was composed of a p-type amorphous silicon-carbide layer 111 of 15 nm thickness, an i-type amorphous silicon photoelectric conversion layer 112 of 0.25 µm thickness and an n-type microcrystalline silicon layer 113 of 15 nm thickness.

After the formation of amorphous silicon photoelectric conversion unit 11, the substrate was taken out from the plasma CVD chamber to the ambient air, and a zinc oxide layer of 30 nm thickness as an intermediate layer 3 was then formed at a substrate temperature of 150°C in an MOCVD chamber. In this MOCVD method, diethyl zinc, water and diborane were introduced in gaseous state into the deposition chamber, i.e., B₂H₆ gas was used for a dopant in the zinc oxide layer.

After the formation of intermediate layer 3, the substrate was taken out from the MOCVD chamber to the ambient air and was immediately introduced into a plasma CVD chamber for forming a crystalline silicon photoelectric conversion unit 12. In this plasma CVD chamber, crystalline silicon photoelectric conversion unit 12 was formed including a p-type microcrystalline silicon layer 121 of 15 nm thickness, an i-type crystalline silicon photoelectric conversion layer 122 of 2.3 µm thickness, and an n-type microcrystalline silicon layer 123 of 15 nm thickness. Thereafter, a zinc oxide layer of 90 nm thickness doped with Al and an Ag layer of 300 nm thickness were deposited in this order by sputtering to form back electrode 13.

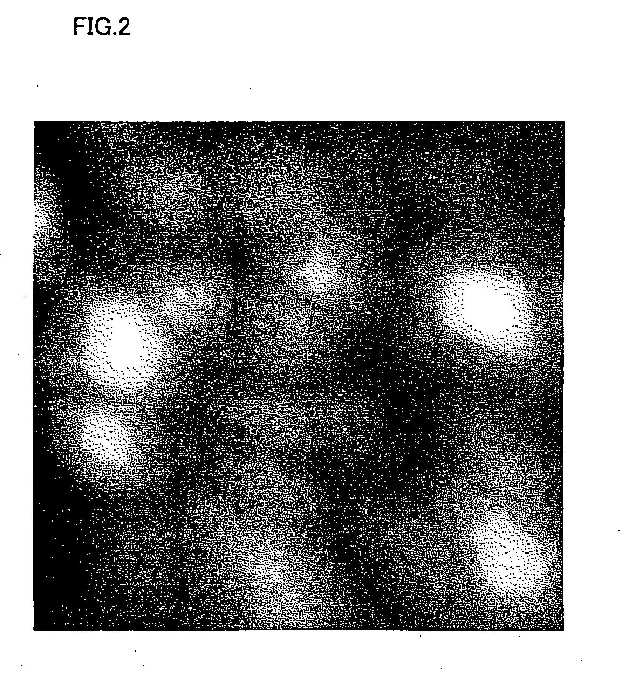

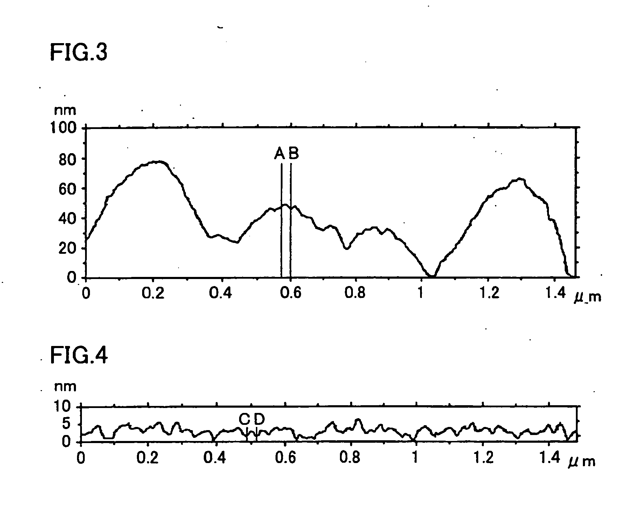

Fig. 2 shows an atomic force microscopy (AFM) image in a square area with a side length of 1.5 µm on the upper surface of intermediate layer 3 formed according to Example 1, and Fig. 3 shows an uneven surface geometry obtained from this AFM measurement. In the graph of Fig. 3, each scale of the lateral axis indicates 0.1 µm, and each scale of the vertical axis indicates 10 nm. The non-contact mode of the nanor system (manufactured by Pacific Nanotechnology, Inc.) was used for this AFM measurement.

In the uneven surface geometry of Fig. 3, a distance between A and B is 28.8 nm, which corresponds to a diameter of one typical small projection (corresponding to a pitch measured parallel to the substrate between two adjacent depressions). In addition to such an unevenness having a small pitch (first uneven surface geometry), there is also anther unevenness having a larger pitch of 300 - 400 nm (second uneven surface geometry) caused by the surface unevenness of front electrode 2, as can be clearly seen in Fig. 3. The height difference d of the second uneven surface geometry is around 60 nm smaller than that of the surface unevenness of front electrode 2 because of interposed amorphous silicon photoelectric conversion unit 11.

An uneven surface geometry of Fig. 4 shows AFM measurement of a zinc oxide film formed on a flat glass plate under similar MOCVD conditions to those for intermediate layer 3 of Example 1. In the graph of Fig. 4, each scale of the lateral axis indicates 0.1 µm and each scale of the vertical axis indicates 5 nm. In this zinc oxide film, a mean surface roughness Sa in an AFM measurement square area with a side length of 1.5 µm was 1.1 nm, which is an averaged value of arithmetic mean roughnesses Ra in the square area. This means that the average height difference of the first uneven surface geometry of intermediate layer 3 is approximately 2.2 nm. In the uneven surface geometry of Fig. 4, a distance between C and D is 23.4 nm, which corresponds to a diameter of one typical small projection (corresponding to a pitch measured parallel to the glass plate between two adjacent depressions).

From comparison between Figs. 3 and 4, it is considered that the uneven surface geometry of intermediate layer 3 in Example 1 was formed in the following manner. That is, intermediate layer 3 was deposited above the uneven surface geometry of transparent electrode 2 (uneven geometry with pitches of 300 - 400 nm in the present example) with interposed photoelectric conversion unit 11 therebetween, so that the surface unevenness of electrode 2 was transmitted to intermediate layer 3 through unit 11 to produce an unevenness with a larger pitch (second uneven surface geometry) while anther unevenness with a smaller pitch (first uneven surface geometry) resulting from growth of intermediate layer 3 is superposed thereon.

When output characteristics of a hybrid thin film photoelectric converter (with a light reception area of 1 cm²) obtained as above in Example 1 were measured at 25°C by illuminating with light of AM1.5 from a solar simulator at a light intensity of 100 mW/cm², the converter had an open circuit voltage (Voc) of 1.36V, a short circuit current density (Jsc) of 11.9 mA/cm², a fill factor (F. F.) of 74.0%, and a conversion efficiency (Eff.) of 12.0%.

### (Example 2)

In Example 2, not falling under the scope of the claims, but being useful for understanding the invention, a hybrid thin film photoelectric converter was fabricated in a manner similar to that in Example 1, except that a zinc oxide film of 30 nm thickness was deposited at a substrate temperature of 150°C by sputtering to form intermediate layer 3.

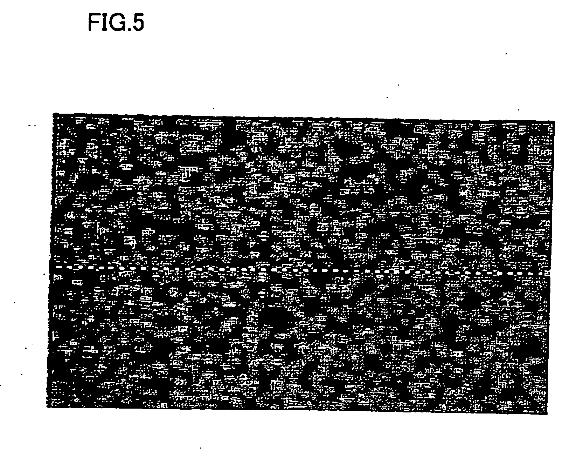

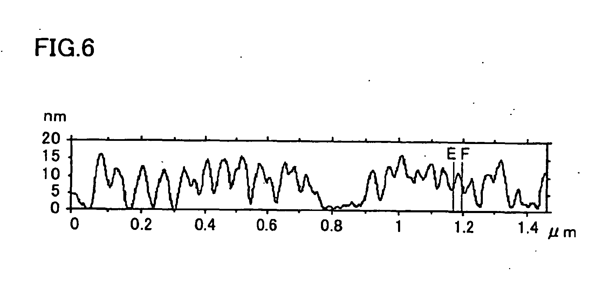

Fig. 5 shows an AFM image of the upper surface (in a rectangular area of 1.5 µm × 9.0 µm) of a zinc oxide film formed on a flat glass plate under sputtering conditions similar to those for intermediate layer 3 of Example 2, and Fig. 6 shows an uneven surface geometry measured by AFM along a broken line in Fig. 5. In the graph of Fig. 6, each scale of the lateral axis indicates 0.1 µm and each scale of the vertical axis indicates 5 nm. In the uneven surface geometry in Fig. 6, the distance between E and F that corresponds.to a diameter of one typical small projection (corresponding to a pitch measured parallel to the glass plate between two adjacent depressions) is 35.2 nm. When a square area of the zinc oxide film with a side length of 1.5 µm on the glass plate was measured by AFM, its mean surface roughness Sa was 3.8 nm. Incidentally, the zinc oxide film was deposited at a rate of about 0.6 nm/sec on the glass plate at 150°C by sputtering.

When output characteristics of a hybrid thin film photoelectric converter (with a light reception area of 1 cm²) obtained in Example 2 were measured at 25°C by illuminating with light of AM1.5 at a light intensity of 100mW/cm², the converter had a Voc of 1.34V, a Jsc of 11.8 mA/cm², an F.F. of 73.5%, and a conversion efficiency of 11.6%.

### (Example 3)

In Example 3, a hybrid thin film photoelectric converter was fabricated in a manner similar to that in Example 1, except that i-type crystalline silicon photoelectric conversion layer 122 had a thickness of 2.7 µm.

When output characteristics of a silicon-based thin film photoelectric converter (with a light reception area of 1 cm²) obtained in Example 3 were measured at 25°C by illuminating with light of AM1.5 at a light intensity of 100 mW/cm², the converter had a Voc of 1.36V, a Jsc of 12.2 mA/cm², an F.F. of 73.6%, and a conversion efficiency of 12.2%.

### (Comparative Example 1)

In Comparative Example 1, a hybrid thin film photoelectric converter was fabricated under conditions and in a process similar to those in Example 1, except that formation of intermediate layer 3 was omitted.

When output characteristics of a hybrid thin film photoelectric converter (with a light reception area of 1 cm²) obtained in Comparative Example 1 were measured at 25°C by illuminating with light of AM1.5 at a light intensity of 100mW/cm², the converter had a Voc of 1.35V, a Jsc of 11.3 mA/cm², an F.F. of 73.1%, and a conversion efficiency of 11.2%.

### (Comparative Example 2)

In Comparative Example 2, a hybrid thin film photoelectric converter was fabricated in a manner similar to that in Example 2, except that the substrate temperature was 190°C instead of 150°C during sputtering for deposition of intermediate layer 3.

A zinc oxide film formed on a glass plate under the same conditions as in the sputtering of Comparative Example 2 exhibited a mean surface roughness Sa of 0.7 nm measured by AFM in a square area with a side length of 1.5 µm. Moreover, the small surface unevenness resulting from growth of the zinc oxide film was not clearly observable in the uneven surface geometry of the zinc oxide film (the average peak-to-peak pitch was smaller than 10 nm). Incidentally, the zinc oxide film was deposited at a rate of about 1.2 nm/sec on the glass plate at 190°C by sputtering.

When output characteristics of a silicon-based thin film photoelectric converter (with a light reception area of 1 cm²) obtained in Comparative Example 2 were measured at 25°C by illuminating with light of AM1.5 at a light intensity of 100 mW/cm², the converter had a Voc of 1.32V, a Jsc of 11.7 mA/cm², an F.F. of 71.8%, and a conversion efficiency of 11.1%.

Table 1 shows major manufacturing conditions for the hybrid thin film photoelectric converters according to above-described Examples 1 to 3 and Comparative Examples 1 and 2, and Table 2 shows measurement results of output characteristics of these photoelectric converters. In Table 2, output current values of amorphous silicon photoelectric conversion unit (front unit) 11 and crystalline silicon photoelectric conversion unit (rear unit) 12, obtained by spectrosensitivity measurement of every hybrid thin film photoelectric converter, are also shown by values normalized with reference to those of Comparative Example 1. Similarly, every total output current value of the front unit and the rear unit in every hybrid thin film photoelectric converter is also shown by a value normalized with reference to that of Comparative Example 1.

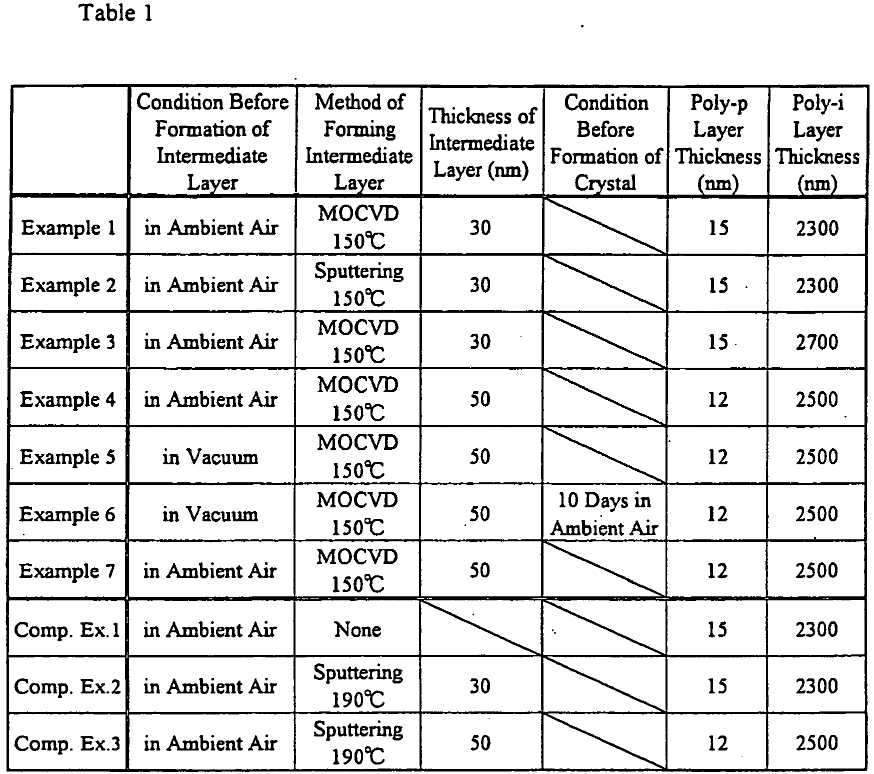

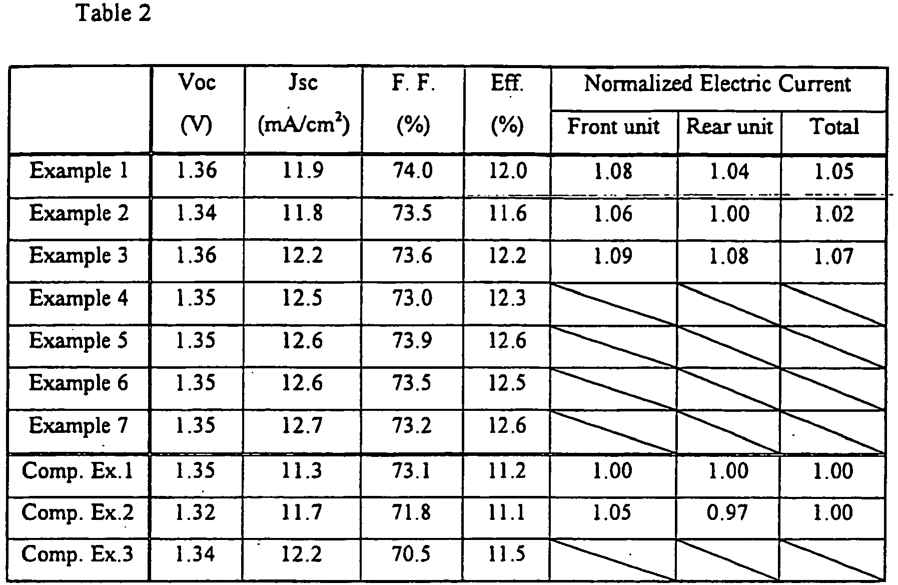

As seen from the results in Table 2, both the short circuit current density (Jsc) and conversion efficiency (Eff.) are improved in any of Examples 1 to 3 as compared to Comparative Examples 1 and 2.

Compared to Comparative Example 1 not including intermediate layer 3, Comparative Example 2 shows an increase of Jsc and an increased output current value of the front unit due to inserted intermediate layer 3, while it shows that the amount of light transmitted to the rear unit is reduced by the amount of light reflected to the front unit by intermediate layer 3. Also, Comparative Example 2 shows Voc and F.F. lower than those of Comparative Example 1, presumably because intermediate layer 3 was deposited by sputtering at a relatively high rate thereby damaging the underlying amorphous photoelectric conversion unit.

In each of Examples 1 to 3, in spite of insertion of intermediate layer 3 having the same thickness as in Comparative Example 2, all the parameters of output characteristics were improved, resulting in the improved conversion efficiency. Particularly, the improvements in Voc and F. F. in each of Examples 1 to 3 as compared with Comparative Example 2 can be attributed to reduced damage of the underlying layer during formation of intermediate layer 3. In each of Examples 1 to 3, the output current value of the rear unit and then that of the entire device were also improved, presumably because the specified uneven surface geometry was formed on intermediate layer 3 itself thereby effectively causing the light trapping effect within the rear unit. Further, since the specified uneven surface geometry of intermediate layer 3 in each of Examples 1 to 3 is completely covered by thin conductive layer 121 of crystalline photoelectric conversion unit 12 formed thereupon, it hardly impairs the output characteristics (especially Voc).

While the effects due to inserted intermediate layer 3 can be seen in each of Examples 1 and 2, it can be seen that intermediate layer 3 having finer uneven surface geometry in Example 1 is more effective in the light scattering and the light trapping. Further, since it is seen in Examples 1 and 2 that the Jsc completely depends on the rear unit, the thickness of the crystalline silicon photoelectric conversion layer of the rear unit was made larger in Example 3, thereby improving the Jsc and also the conversion efficiency in the hybrid thin film photoelectric converter of Example 3.

### (Example 4)

In Example 4 also, a hybrid thin film photoelectric converter was fabricated in a manner similar to that in Example 1. In Example 4, however, some layers were changed in thickness such that this example is different from Example 1 in that intermediate layer 3 was formed to 50 nm thickness by MOCVD; crystalline silicon photoelectric conversion unit 12 included p-type microcrystalline silicon layer 121 of 12 nm thickness (poly-p Layer Thickness in Table 1 (nm)), i-type crystalline silicon photoelectric conversion layer 122 of 2.5 µm thickness (poly-i Layer Thickness in Table 1 (nm)), and n-type microcrystalline silicon layer 123 of 15 nm thickness; and a zinc oxide layer of 90 nm thickness doped with Al and then an Ag layer of 240 nm thickness were deposited for back electrode 13 by sputtering.

When output characteristics of a silicon-based thin film photoelectric converter (with a light reception area of 1 cm²) obtained in Example 4 were measured at 25°C by illuminating with light of AM 1.5 at a light intensity of 100 mW/cm², the converter had a Voc of 1.35V, a Jsc of 12.5mA /cm², an F.F. of 73.0%, and a conversion efficiency of 12.3%.

### (Comparative Example 3)

In Comparative Example 3, a hybrid thin film photoelectric converter was fabricated in a manner similar to that in Example 4, except that intermediate layer 3 was formed by sputtering at a substrate temperature of 190°C.

When output characteristics of a silicon-based thin film photoelectric converter (with a light reception area of 1 cm²) obtained in Comparative Example 3 were measured at 25°C by illuminating with light of AM1.5 at a light intensity of 100 mW/cm², the converter had a Voc of 1.34V, a Jsc of 12.2mA /cm², an F.F. of 70.5%, and a conversion efficiency of 11.5%.

The hybrid thin film photoelectric converter of Example 4 has output characteristics better than those of Comparative Example 3 (see Tables 1 and 2). The improvement in the fill factor (F. F.) supposedly depends on whether or not damage of underlying amorphous silicon photoelectric conversion unit 11 was caused by the method of depositing intermediate layer 3. More specifically, it is considered in Comparative Example 3 that amorphous silicon photoelectric conversion unit 11 was damaged during the formation of intermediate layer 3 by sputtering, thereby deteriorating the interface between unit 11 and intermediate layer 3, resulting in the reduced fill factor. In Example 4, on the other hand, amorphous silicon photoelectric conversion unit 11 was not damaged presumably because intermediate layer 3 was formed by chemical vapor phase reaction. Further, Example 4 has its short circuit current Jsc lager than that of Comparative Example 3. This improvement supposedly depends on the difference in transmissivity or fine uneven surface geometry resulting from growth of intermediate layer 3 itself.

### (Example 5)

A hybrid thin film photoelectric converter of Example 5 is different from that of Example 4 in that, after formation of amorphous silicon photoelectric conversion unit 11, the substrate was being kept in vacuum (Condition Before Formation of Intermediate Layer in Table 1) without being taken out to the ambient air and introduced into a deposition chamber for formation of intermediate layer 3.

When output characteristics of a silicon-based thin film photoelectric converter (with a light reception area of 1 cm²) obtained in Example 5 were measured at 25°C by illuminating with light of AM1.5 at a light intensity of 100 mW/cm², the converter had a Voc of 1.35V, a Jsc of 12.6mA /cm², an F.F. of 73.9%, and a conversion efficiency of 12.6%.

The conversion efficiency of the hybrid thin film photoelectric converter of Example 5 is higher than those of Example 4 and Comparative Example 3, because intermediate layer 3 was formed directly after the formation of amorphous silicon photoelectric conversion unit 11, without the substrate being taken out to the ambient air (see Tables 1 and 2). Specifically, the sate of the interface joining the upper surface of n-type microcrystalline silicon layer 113 and intermediate layer 3 was further improved presumably because the upper surface of amorphous photoelectric conversion unit 11 was not exposed to the ambient air, thereby preventing its contamination and natural oxidation.

### (Example 6)

A hybrid thin film photoelectric converter of Example 6 is only different from that of Example 5 in that the substrate was taken out to the ambient air after deposition of intermediate layer 3 and was held for 10 days (Condition Before Formation of Crystal in Table 1) before being introduced into a plasma CVD apparatus for forming crystalline silicon photoelectric conversion unit 12.

When output characteristics of a silicon-based thin film photoelectric converter (with a light reception area of 1 cm²) obtained in Example 6 were measured at 25°C by illuminating with light of AM1.5 at a light intensity of 100 mW/cm², the converter had a Voc of 1.35V, a Jsc of 12.6mA /cm², an F.F. of 73.5%, and a conversion efficiency of 12.5%.

Although the substrate was left in the ambient air for 10 days after the deposition of intermediate layer 3 in Example 6, the conversion efficiency of Example 6 was approximately the same as that of Example 5 in which the substrate was introduced into the plasma CVD apparatus for forming crystalline silicon photoelectric conversion unit 12 immediately after the formation of intermediate layer 3 (see Tables 1 and 2). Thus, even though a substrate is left in the ambient air for a substantial period of time after deposition of intermediate layer 3, a resultant photoelectric converter is not deteriorated in its performance. This means that, in manufacturing photoelectric converters according to the present invention, different plasma CVD apparatus can be operated and managed independently of each other for forming amorphous silicon photoelectric conversion unit 11 and crystalline silicon photoelectric conversion unit 12, for example. That is, it is advantageous that plasma CVD apparatus can be efficiently operated and separately maintained, even when the plasma CVD apparatus require different durations of forming respective photoelectric conversion units.

### (Example 7)

In Example 7, a hybrid thin film photoelectric converter was fabricated in a manner similar to that in Example 4, except that diborane gas was not added during deposition of intermediate layer 3 in MOCVD.

When output characteristics of a silicon-based thin film photoelectric converter (with a light reception area of 1 cm²) obtained in Example 7 were measured at 25°C by illuminating with light of AM1.5 at a light intensity of 100 mW/cm², the converter had a Voc of 1.35V, a Jsc of 12.7mA /cm², an F.F. of 73.2%, and a conversion efficiency of 12.6%.

The hybrid thin film photoelectric converter of Example 7 has its Jsc larger than that of Example 4 (see table 2), presumably because intermediate layer 3 in Example 7 was formed without doping with diborane gas, thereby increasing the transparency of intermediate layer 3 itself and increasing the first surface unevenness inherent in the intermediate layer so that the light trapping effect was more enhanced.

Further, since the F. F. is improved in Example 7 compared with Example 4 (see Table 2), it is considered that in the case of the intermediate layer being as thin as in Example 7 (50 nm), the properties of the photoelectric converter are not significantly decreased by the resistivity increase due to the absence of doping; rather, it becomes possible to improve the state of tunnel junction (n layer/p layer) between the two photoelectric conversion units.

### Industrial Applicability

As described above, the present invention can provide a method of manufacturing for a tandem thin film photoelectric converter with improved conversion efficiency by inserting a light transmissive intermediate layer having a specified uneven surface geometry along at least one interface between a plurality of photoelectric conversions units. Further, according to the present invention, a tandem thin film photoelectric converter with improved conversion efficiency can be manufactured with good productivity by forming an intermediate layer by chemical vapor phase reaction so as not to cause damage to an underlying photoelectric conversion unit.

## Claims

1. A method of manufacturing a tandem thin film photoelectric converter, comprising the steps of:
depositing a transparent electrode (2), a plurality of photoelectric conversion units (11, 12) and a back electrode (13) in sequence on a transparent insulating substrate (1),wherein said plurality of photoelectric conversion units include one or more amorphous photoelectric conversion units (11) and one or more crystalline photoelectric conversion units (12);
forming an intermediate layer (3) for partially reflecting and partially transmitting light by chemical vapor deposition, wherein said intermediate layer (3) includes as its main component a transparent conductive oxide containing zinc oxide, tin oxide or indium-tin oxide,
wherein the intermediate layer (3) is inserted along an interface between an amorphous photoelectric conversion unit (11) and a crystalline photoelectric conversion unit (12) among said plurality of photoelectric conversion units;
wherein said intermediate layer has an average thickness in a range of 20-60 nm, the upper surface of said intermediate layer includes a first uneven surface geometry having a first average peak-to-peak pitch in a range of 10-50 nm and the upper surface of said transparent electrode (2) includes an uneven surface geometry having an average peak-to-peak pitch in a range of 200-900 nm.

2. The method according to claim 1, wherein at the upper surface of said intermediate layer (3), a second uneven surface geometry having a second average peak-to-peak pitch different from said first average peak-to-peak pitch is superposed on said first uneven surface geometry.

3. The method according to claim 2, wherein said second average peak-to-peak pitch at the upper surface of said intermediate layer (3) is caused by the uneven surface geometry formed at an upper surface of said transparent electrode (2).

4. The method according to claim 2, wherein said second average peak-to-peak pitch is larger than said first average peak-to-peak pitch.

5. The method according to claim 1, wherein all materials used to form said intermediate layer (3) are introduced in vapor phase into a deposition chamber from its outside.

6. The method according to claim 1, wherein said intermediate layer (3) is formed directly after the amorphous photoelectric conversion unit (11) has been formed above said substrate (1), without the upper surface of said unit being exposed to the ambient air.

## Patentansprüche

1. Verfahren zum Herstellen eines photoelektrischen Tandem-Dünnfilmwandlers, das die Schritte aufweist:
Abscheiden einer transparenten Elektrode (2), mehrerer photoelektrischer Umwandlungseinheiten (11, 12) und einer Rückelektrode (13) der Reihe nach auf einem transparenten isolierenden Substrat (1), wobei die mehreren photoelektrischen Umwandlungseinheiten eine oder mehrere amorphe photoelektrische Umwandlungseinheiten (11) und
eine oder mehrere kristalline photoelektrische Umwandlungseinheiten (12) aufweisen; Bilden eine Zwischenschicht (3) zum teilweisen Reflektieren und teilweisen Durchlassen von Licht durch chemische Abscheidung aus der Dampfphase, wobei die Zwischenschicht (3) als ihren Hauptbestandteil ein transparentes leitfähiges Oxid aufweist, das Zinkoxid, Zinnoxid oder Indium-Zinnoxid enthält,
wobei die Zwischenschicht (3) längs einer Grenzfläche zwischen einer amorphen photoelektrischen Umwandlungseinheit (11) und einer kristallinen photoelektrischen Umwandlungseinheit (12) zwischen den mehreren photoelektrischen Umwandlungseinheiten eingeschoben wird;
wobei die Zwischenschicht eine durchschnittliche Dicke in einem Bereich von 20-60 nm aufweist, die Oberseite der Zwischenschicht eine erste unebene Oberflächengeometrie aufweist, die einen ersten durchschnittlichen Spitze-Spitze-Abstand in einem Bereich von 10-50 mn aufweist, und die Oberseite der transparenten Elektrode (2) eine unebene Oberflächengeometrie aufweist, die einen durchschnittlichen Spitze-Spitze-Abstand in einem Bereich von 200-900 nm aufweist.

2. Verfahren nach Anspruch 1, wobei auf der Oberseite der Zwischenschicht (3) eine zweite unebene Oberflächengeometrie, die einen zweiten durchschnittlichen Spitze-Spitze-Abstand aufweist, der sich vom ersten durchschnittlichen Spitze-Spitze-Abstand unterscheidet, auf der ersten unebenen Oberflächengeometrie überlagert ist.

3. Verfahren nach Anspruch 2, wobei der zweite durchschnittliche Spitze-Spitze-Abstand auf der Oberseite der Zwischenschicht (3) durch die unebene Oberflächengeometrie bewirkt wird, die auf einer Oberseite der transparenten Elektrode (2) ausgebildet ist.

4. Verfahren nach Anspruch 2, wobei der zweite durchschnittliche Spitze-Spitze-Abstand größer als der erste durchschnittliche Spitze-Spitze-Abstand ist.

5. Verfahren nach Anspruch 1, wobei alle zur Bildung der Zwischenschicht (3) verwendeten Materialien in einer Dampfphase in eine Abscheidungskammer von außen eingeleitet werden.

6. Verfahren nach Anspruch 1, wobei die Zwischenschicht (3) gebildet wird, direkt nachdem die amorphe photoelektrische Umwandlungseinheit (11) über dem Substrat (1) gebildet worden ist, ohne dass die Oberseite der Einheit der Umgebungsluft ausgesetzt wird.

## Revendications

1. Procédé de fabrication d'un convertisseur photoélectrique à couche mince en tandem, comprenant les étapes de :
dépôt séquentiel sur un substrat isolant transparent (1) d'une électrode transparente (2), d'une pluralité d'unités de conversion photoélectriques (11, 12) et d'une électrode arrière (13), la pluralité d'unités de conversion photoélectriques comportant une ou plusieurs unités de conversion photoélectriques amorphes (11) et une ou plusieurs unités de conversion photoélectriques cristallines (12) ;
formation d'une couche intercalaire (3) pour une réflexion partielle et une transmission partielle de lumière par dépôt chimique en phase vapeur, ladite couche intercalaire (3) comprenant comme composant principal un oxyde conducteur transparent contenant de l'oxyde de zinc, de l'oxyde d'étain ou de l'oxyde d'indium-étain,
la couche intercalaire (3) étant insérée le long d'une interface entre une unité de conversion photoélectrique amorphe (11) et une unité de conversion photoélectrique cristalline (12) parmi la pluralité d'unités de conversion photoélectriques ;
la couche intercalaire ayant une épaisseur moyenne comprise entre 20 et 60 nm, la surface supérieure de la couche intercalaire présentant une première géométrie de surface non plane avec une première amplitude crête à crête moyenne comprise entre 10 et 50 nm, et la surface supérieure de l'électrode transparente (2) présentant une géométrie de surface non plane avec une amplitude crête à crête moyenne comprise entre 200 et 900 nm.

2. Procédé selon la revendication 1, où, à la surface supérieure de la couche intercalaire (3), une deuxième géométrie de surface non plane avec une deuxième amplitude crête à crête moyenne différente de la première amplitude crête à crête moyenne est superposée à la première géométrie de surface non plane.

3. Procédé selon la revendication 2, où la deuxième amplitude crête à crête moyenne à la surface supérieure de la couche intercalaire (3) est due à la géométrie de surface non plane formée à une surface supérieure de l'électrode transparente (2).

4. Procédé selon la revendication 2, où la deuxième amplitude crête à crête moyenne est supérieure à la première amplitude crête à crête moyenne.

5. Procédé selon la revendication 1, où tous les matériaux utilisés pour former la couche intercalaire (3) sont introduits en phase vapeur dans une chambre de dépôt depuis l'extérieur de celle-ci.

6. Procédé selon la revendication 1, où la couche intercalaire (3) est formée immédiatement après la formation au-dessus du substrat (1) d'une unité de conversion photoélectrique amorphe (11), sans exposition à l'air ambiant de la surface supérieure de l'unité.
